# EUROPÄISCHE PATENTSCHRIFT

(11) **EP 1 756 326 B1**
(45) Veröffentlichungstag und Bekanntmachung des Hinweises auf die Patenterteilung: **30.09.2009**
(21) Anmeldenummer: 05758913.7
(22) Anmeldetag: 08.06.2005
(51) Int. Cl.: C23C 14/24

(54) **TRANSPORTSYSTEM FÜR NANOPARTIKEL UND VERFAHREN ZU DESSEN BETRIEB**
TRANSPORT SYSTEM FOR NANOPARTICLES AND METHOD FOR THE OPERATION THEREOF
SYSTEME DE TRANSPORT DE NANOPARTICULES ET SON MODE DE FONCTIONNEMENT

(30) Priorität: 18.06.2004 DE 102004030523
(43) Veröffentlichungstag der Anmeldung: 28.02.2007
(73) Patentinhaber: SIEMENS AKTIENGESELLSCHAFT, 80333 München (DE)
(72) Erfinder: JENSEN, Jens Dahl, 14050 Berlin (DE); KRÜGER, Ursus, 14089 Berlin (DE); LÜTHEN, Volkmar, 12157 Berlin (DE); SCHIEWE, Heike, 12167 Berlin (DE)
(86) Internationale Anmeldenummer: PCT/DE2005/001051
(87) Internationale Veröffentlichungsnummer: WO 2005/123978

(56) Entgegenhaltungen:
- DE-A1- 19 632 393
- GB-A- 2 148 152
- US-A- 4 132 892
- US-A1- 2003 077 398
- DATABASE WPI Section PQ, Week 200269 Derwent Publications Ltd., London, GB; Class Q31, AN 2002-637354 XP002343622 & CN 1 359 840 A (UNIV BEIJING CHEM) 24. Juli 2002 (2002-07-24)

## Beschreibung

Die Erfindung betrifft ein Transportsystem für Nanopartikel. Als trockene Nanopartikel werden kleinste Teilchen mit Abmessungen im Nanometer-Bereich verstanden, die jeweils aus einer Vielzahl von Atomen oder Molekülen zusammengesetzt sind. Wenn diese trocken sind, bilden sie ein nanodisperses Pulver, d. h. es ist kein flüssiges Trägermedium für die Nanopartikel zum Transport vorgesehen.

Aus der DE 196 32 393 A1 lässt sich entnehmen, dass diese sog. Nanopulver nicht ohne Weiteres rieselfähig sind, wodurch die externe Einspeisung beispielsweise in einen PVD-Prozess problematisch ist. Daher ist vorgesehen, Nanopulver nicht als Ausgangsmaterial zur Einspeisung in PVD-Prozesse zu verwenden, sondern die Nanoteilchen vielmehr in situ innerhalb des PVD-Prozesses herzustellen. Für die herzustellenden Nanopartikel müssen zu diesem Zweck geeignete Ausgangsstoffe in den PVD-Prozess (Physical Vapour Deposition) eingespeist werden.

Die Aufgabe der Erfindung besteht darin, ein Transportsystem für Nanopartikel anzugeben, mit dem der Transport von Nanopulvern möglich ist.

Diese Aufgabe wird erfindungsgemäß durch ein Transportsystem für trockene, magnetisierte Nanopartikel, aufweisend einen Transportkanal für die Nanopartikel und einen Felderzeuger für ein magnetisches Feld, der in Bezug auf den Transportkanal derart angeordnet ist, dass das Magnetfeld im Transportkanal inhomogen mit im Wesentlichen entlang dem Verlauf des Transportkanals ausgerichteten Feldlinien erzeugt werden kann, gelöst. Dabei wird vorteilhaft der Effekt ausgenutzt, dass auf die magnetisierten Nanopartikel durch das inhomogene Magnetfeld im Inneren des Transportkanals eine entlang den Feldlinien des Magnetfeldes ausgerichtete Kraft in Richtung wachsender magnetischer Induktion ausgeübt wird.

Eine alternative Lösung der genannten Aufgabe wird durch ein Transportsystem für trockene, elektrisch geladenen Nanopartikel, aufweisend einen Transportkanal für die Nanopartikel und einen Felderzeuger für ein elektrisches Feld, der in Bezug auf den Transportkanal derart ausgerichtet ist, dass das elektrische Feld mit zumindest im Wesentlichen entlang dem Verlauf des Transportkanals ausgerichteten Feldlinien erzeugt werden kann. Bei dieser Alternative wird vorteilhaft bei elektrisch geladenen Nanopartikeln der Effekt genutzt, dass auf diese im elektrischen Feld eine Kraft entlang der Feldlinien wirkt.

Bei dem erfindungsgemäßen Transportsystem für Nanopartikel wird der Effekt genutzt, dass die Nanopartikel aufgrund ihrer sehr geringen Masse schon durch geringe Kräfte bewegt werden können, so dass bereits eine geringe Magnetisierung bzw. Ladung der Nanopartikel für einen Transport im Transportsystem ausreicht. Es hat sich nämlich gezeigt, dass Nanopartikel bei ihrem Transport ein Verhalten zeigen, welches von dem Verhalten gewöhnlicher Pulverteilchen mit Teilchengrößen im Mikrometer-Bereich stark abweicht. Nanopartikel zeigen aufgrund ihrer geringen Partikelgröße vielmehr ein zu einzelnen Ladungsträgern wie Ionen verwandtes Verhalten beim Transport.

Ausgestaltungen des erfindungsgemäßen Transportsystems sehen vor, dass der Felderzeuger für ein magnetisches Feld durch eine elektrische Spule gebildet werden kann, die als Wicklung um den Transportkanal ausgeführt ist. Im Bereich der Spule entsteht in dem Transportkanal ein homogenes Magnetfeld, welches sich mit zunehmender Entfernung von der Spule im Tansportkanal abschwächt. Magnetisierte Nanopartikel werden daher zur Spule hin beschleunigt. Ein Felderzeuger für ein elektrisches Feld kann z. B. einen Kondensator aufweisen.

Eine besondere Ausgestaltung der Erfindung sieht vor, dass der Transportkanal in eine Ausstoßöffnung für die Nanopartikel mündet. Damit kann das Transportsystem auch vorteilhaft als Düse verwendet werden, wobei die Nanopartikel mittels der Düse beispielsweise auf einer Oberfläche oder in einem Volumen gleichmäßig verteilt werden können. Ein Transportsystem mit Ausstoßöffnung kann beispielsweise auch bei PVD-Verfahren wie z. B. beim Lichtbogen-Verdampfen eingesetzt werden, um die Nanopartikel gleichmäßig in eine PVD-Schicht einbauen zu können.

Gemäß einer besonderen Ausgestaltung ist das Transportsystem dadurch gekennzeichnet, dass die Innenwand des Transportkanals radial zu dessen Verlauf beweglich ist und mit einem Aktor ausgestattet ist, derart, dass der Aktor Bewegungen der Innenwand senkrecht zur Wandfläche erzeugen kann. Hiermit kann vorteilhaft eine Adhäsion von Nanopartikeln an der Innenwand des Transportkanals vermindert oder sogar unterdrückt werden. Hierdurch wird der Transport der Nanopartikel durch den Felderzeuger erleichtert, insbesondere kann ein Verstopfen des Transportkanals verhindert werden. Folglich wird es möglich, einen Transport von Nanopartikeln auch in Kanälen mit sehr geringen Durchmessern, die bei einem drei- bis fünffachen des Partikeldurchmessers der Nanopartikel liegen, zu gewährleisten. Besonders vorteilhaft wird der Aktor durch ein Piezoaktor gebildet, der beispielsweise Schwingungen der Innenwand im Ultraschallbereich bewirken kann.

Weiterhin betrifft die Erfindung ein Verfahren zum Betrieb eines Transportsystems für Nanopartikel. Die Aufgabe der Erfindung besteht diesbezüglich darin, Verfahren zum Betrieb von Transportsystemen für Nanopartikel anzugeben, mit denen ein Transport der Nanopartikel optimal an den jeweiligen Anwendungsfall angepasst werden können.

Diese Aufgabe wird erfindungsgemäß durch ein Verfahren gelöst, bei dem in dem Transportkanal des Transportsystems ein statisches Feld erzeugt wird, welches aufrechterhalten bleibt, solange die Nanopartikel kontinuierlich gefördert werden sollen. Dies ist sowohl für magnetisierte Nanopartikel mittels eines geeigneten Magnetfeldes, als auch für elektrisch geladene Nanopartikel mittels eines elektrischen Feldes oder auch mittels einer Überlagerung eines elektrischen und magnetischen Feldes bei geeigneten Eigenschaften der Nanopartikel möglich. Der Felderzeuger stellt somit den Transportmechanismus zum Transport der Nanopartikel zur Verfügung, so lange er ein Feld erzeugt.

Eine alternative Lösung der Aufgabe besteht in einem Verfahren, bei dem in dem Transportkanal ein pulsierendes Feld erzeugt wird, wobei durch Einstellung der Pulse eine Dosierung der Nanopartikel vorgenommen wird. Die zeitliche Änderung der Feldstärke des getakteten Feldes kann entsprechend den Anforderungen an die Dosierung eingestellt werden. Die zeitliche Änderung kann durch Variation der Pulslänge, der Pulshöhe, des Pulsabstandes und der Pulsform beeinflusst werden. Die Dosierung der Nanopartikel erfolgt in Abhängigkeit davon durch ein jeweils zeitlich begrenztes Ausstoßen bzw. Transportieren der Nanopartikel im Transportkanal.

Weitere Einzelheiten der Erfindung werden im Folgenden anhand der Zeichnung beschrieben. In der Zeichnung sind gleiche oder sich entsprechende Zeichnungselemente mit jeweils denselben Bezugszeichen versehen und werden, soweit sich Übereinstimmungen zwischen den einzelnen Figuren ergeben, nur einmal erläutert. Es zeigen
- Figur 1: ein Ausführungsbeispiel des erfindungsgemäßen Transportsystems mit Magnetfelderzeuger schema- tisch,
- Figur 2: ein Ausführungsbeispiel des erfindungsgemäßen Transportsystems mit Felderzeuger für ein elektri- sches Feld schematisch,
- Figur 3: ein Ausführungsbeispiel des Transportsystems als Düse geschnitten und
- Figur 4: eine PVD-Beschichtungsanlage mit einer Düse gemäß Figur 3 schematisch.

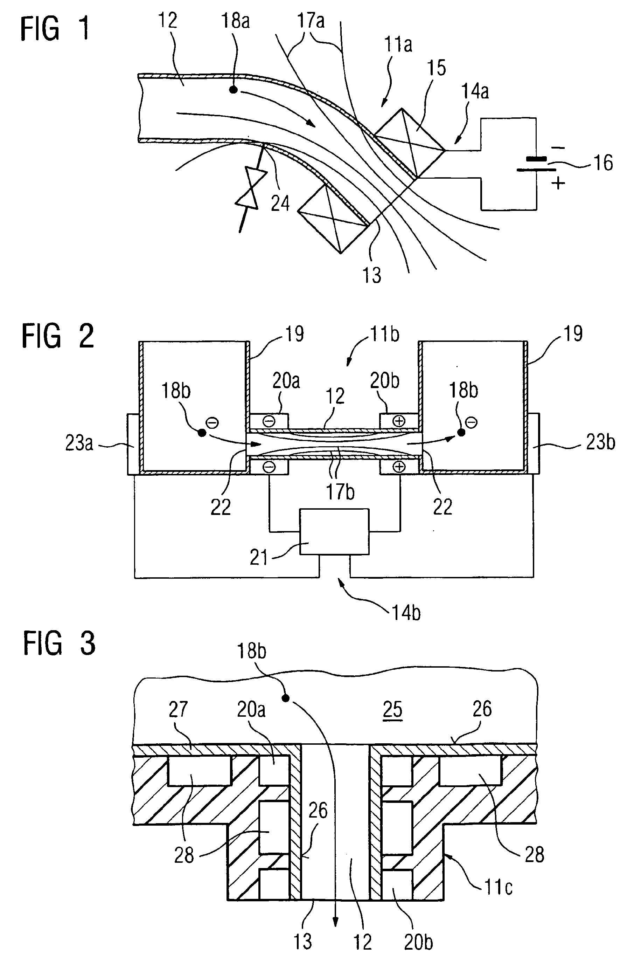

Gemäß Figur 1 ist ein Transportsystem 11a dargestellt, welches einen Transportkanal 12 aufweist, der in einer Ausstoßöffnung 13 endet. Im Bereich der Ausstoßöffnung ist weiterhin ein Felderzeuger 14a vorgesehen, der aus einer elektrischen Spule 15 und einer Stromversorgung 16 besteht. Die Spule 15 umschließt ringartig den Transportkanal 12 an der Ausstoßöffnung 13, so dass im Bereich der Ausstoßöffnung 13 ein homogenes Magnetfeld im Inneren des Transportkanals 12 entsteht (angedeutet durch magnetische Feldlinien 17a). Das im weiteren dargestellten Verlauf des Transportkanals 12 ausgebildete Magnetfeld außerhalb der Spule 15 dagegen ist inhomogen, wobei die magnetische Induktion mit zunehmender Entfernung von der Spule abnimmt.

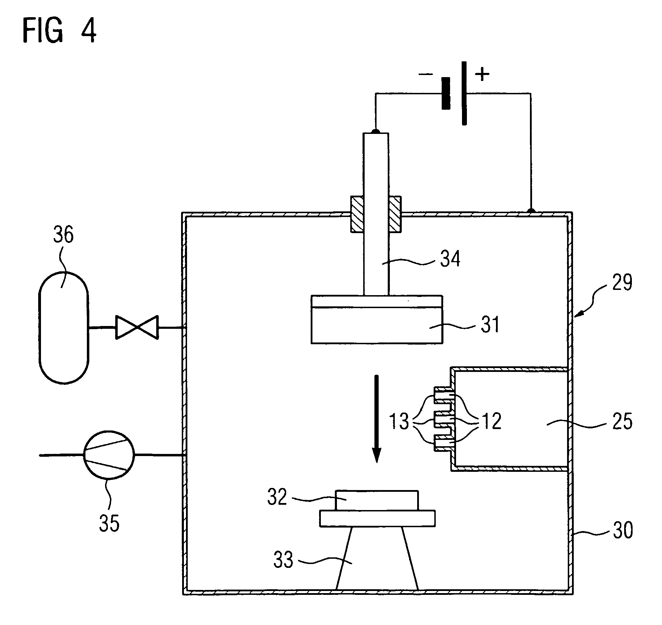

Der Verlauf des Transportkanals 12 folgt im Wesentlichen dem Verlauf bestimmter Feldlinien des erzeugten magnetischen Feldes, wobei hierbei eine Krümmung des Transportkanals realisiert ist. Alternativ (nicht dargestellt) kann der Transportkanal auch gerade ausgeführt werden, da sich auch gesehen in der Symmetrieachse der Spule 15 das Magnetfeld mit zunehmender Entfernung von der Spule abschwächt. Ein magnetisiertes Nanoteilchen 18a (beispielsweise aus einem ferromagnetischen Material wie Eisen) richtet sich in dem durch die Spule 15 gebildeten, inhomogenen Magnetfeld aus und wird innerhalb des Transportkanals 12 in Richtung der Bereiche des Magnetfeldes mit steigender magnetischer Induktion, also hin zur Spule 15 beschleunigt. Im Inneren der Spule 15 herrscht ein homogenes Magnetfeld, so dass das Nanopartikel beim Durchtritt durch diesen Bereich nicht weiter beschleunigt wird. Anschließend wird es aus der Ausstoßöffnung 13 ausgestoßen und im freien Raum aufgrund des nun schwächer werdenden Magnetfeldes wieder abgebremst. Hier kann es aber beispielsweise durch einen Teilchenstrom eines PVD-Prozesses erfasst werden (vgl. Figur 4) .

Zuletzt ist an dem Transportkanal 12 ein Druckluftanschluss 24 mit Ventil vorgesehen, durch den Druckluftimpulse in den Transportkanal eingespeist werden können. Der Druckluftanschluss kann in nicht dargestellter Weise auch mehrere Eintrittsöffnungen in den Transportkanal 12 aufweisen, um die Druckluft gleichmäßig über die Wandungen des Transportkanals zu verteilen. Durch die Druckluftstöße lässt sich eine Adhäsion der Nanopartikel 18a an die Wände des Transportkanals 12 verhindern.

Ein Transportsystem 11b gemäß Figur 2 verbindet zwei Behälter 19 miteinander, zwischen denen elektrisch geladene Nanopartikel 18b ausgetauscht werden sollen. Zu diesem Zweck ist der Transportkanal 12 an seinen Enden mit Ringelektroden 20a, 20b ausgestattet, die mit einer elektrischen Steuereinheit 21 zusammen einen als Kondensator ausgeführten Felderzeuger 14b für ein elektrisches Feld im Inneren des Transportkanals 12 bilden (Feldlinien 17b des elektrischen Feldes). Mittels der Steuereinheit 21 können die Ringelektroden 20a, 20b zur Erzeugung des elektrischen Feldes angesteuert werden. Das elektrische Feld im Inneren des Transportkanals 12 übt eine Kraft auf die elektrisch geladenen, im Transportkanal befindlichen Nanopartikel 18b, aus, so dass diese vom einen in den anderen der Behälter 19 wechseln können. Ein Richtungswechsel des Transportes durch den Transportkanal 12 kann durch eine Umpolung der Ringelektroden 20a, 20b durch die Steuereinheit 21 erfolgen.

Weiterhin sind gegenüber von Mündungen 22 des Transportkanals 12 in die Behälter 19 Zusatzelektroden 23a, 23b in die Wandungen der Behälter 19 integriert, so dass auch in den Behältern bereits ein elektrisches Feld aufgebaut werden kann, welches den Eintritt bzw. den Austritt der Nanopartikel 18b in bzw. aus dem Transportkanal 12 erleichtert.

Gemäß Figur 3 ist ein Transportsystem 11c dargestellt, welches einen als Düse ausgeführten Transportkanal 12 mit einer Ausstoßöffnung 13 aufweist. Der Transportkanal mündet an seinem der Ausstoßöffnung 13 abgewandten Ende in ein Reservoir 25 für Nanopartikel 18b. Eine Innenwand 26 sowohl des Reservoirs 25 wie auch des Transportkanals 12 ist durch eine Beschichtung 27 gebildet, die für das Transportsystem 11c verschiedene Funktionen übernehmen kann. Es ist eine elektrische Isolation der Ringelektroden 20a, 20b möglich. Weiterhin kann an der Beschichtung 27 eine statische Aufladung der Nanopartikel 18b erfolgen, so dass diese elektrisch geladen vorliegen. Zuletzt ist die Beschichtung 27 elastisch ausgeführt, so dass diese sich beispielsweise senkrecht zur Wandfläche der Innenwand 26 bewegen kann. Als Aktoren zur Erzeugung solcher Bewegungen sind Piezoaktoren 28 in das Wandmaterial des Kanals 12 und des Reservoirs 25 eingelassen. Die elektrische Kontaktierung der Piezoaktoren 28 sowie der ebenfalls in das Wandmaterial eingebetteten Ringelektroden 20a, 20b sind der Übersichtlichkeit halber nicht dargestellt.

Durch die Piezoaktoren können beispielsweise Schwingungen erzeugt werden, die über die Beschichtung 27 auf die Nanopartikel 18b wirken. Hiermit wird einer Adhäsion der Nanopartikel an die Innenwand 26 entgegengewirkt. Durch Aktivierung der Ringelektroden 20a, 20b kann weiterhin ein Ausstoß der Nanopartikel 18b aus dem Transportkanal 12 bewirkt werden. Durch Anlegen einer Gleichspannung an die Ringelektroden 20a, 20b kann beispielsweise ein kontinuierlicher Fluss von Nanoteilchen 18b erzeugt werden. Es ist jedoch auch eine Dosierung von Nanoteilchen 18b möglich, indem die Ringelektroden 20a, 20b mit einem gepulsten oder auch Wechselstrom beaufschlagt werden. In diesen Fällen trägt das zeitlich veränderliche, durch die Ringelektroden 20a, 20b erzeugte, elektrische Kondensatorfeld ebenfalls dazu bei, dass ein Anlagern von Nanoteilchen an der Innenwand 26 unterbunden wird. Die möglichen Verfahren zur Ansteuerung der Ringelektroden 20a, 20b können selbstverständlich auch bei der Spulenanordnung gemäß Figur 1 zur Anwendung kommen.

In Figur 4 ist eine PVD-Beschichtungsanlage 29 dargestellt, in der beispielsweise ein Array von an einem Reservoir 25 angeschlossenen Transortkanäle 12 mit Ausstoßöffnungen 13 zur Anwendung kommen kann, um einzelne Nanopartikel in den PVD-Beschichtungsprozess einzubringen. Die PVD-Beschichtungsanlage besteht im Wesentlichen aus einer Vakuumkammer 30, in der ein Target 31 gegenüber einem zu beschichtenden Substrat 32 angeordnet ist. Das Substrat liegt auf einen elektrisch neutralen Sockel 33, während das Target 31 auf einem als Anode ausgebildeten Halter 34 angeordnet ist. Die Wand der Vakuumkammer 30 bildet die zugehörige Kathode.

Mittels einer Vakuumpumpe 35 kann die Vakuumkammer evakuiert werden, wobei aus einem Vorratsbehälter 36 ein Reaktionsgas in die Vakuumkammer eingeleitet werden kann. Mit Hilfe des Reaktionsgases lässt sich in der Vakuumkammer 30 ein Plasma zünden, welches aus dem Target 31 Teilchen zur Abscheidung auf dem Substrat 32 herauslöst. In diesen Teilchenstrom werden die Nanopartikel mit Hilfe der Transportkanäle 12 eingeleitet, so dass diese in die Beschichtung eingebaut werden. Die Nanopartikel können auch in den Lichtbogen einer Lichtbogenverdampfungsanlage eingespeist werden (nicht dargestellt).

## Patentansprüche

1. Transportsystem für trockene, magnetisierte Nanopartikel, aufweisend
- einen Transportkanal (12) für die Nanopartikel und
- einen Felderzeuger (14a) für ein magnetisches Feld, der im Bezug auf den Transportkanal derart angeordnet ist, dass das Magnetfeld im Tranportkanal inhomogen mit im Wesentlichen entlang dem Verlauf des Transportkanals ausgerichteten Feldlinien erzeugt werden kann.

2. Transportsystem nach Anspruch 1,
**dadurch gekennzeichnet,**
**dass** der Felderzeuger (14a) für das magnetische Feld eine elektrische Spule (15) aufweist, die als Wicklung um den Transportkanal (12) ausgeführt ist.

3. Transportsystem für trockene, elektrisch geladene Nanopartikel, aufweisend
- einen Transportkanal (12) für die Nanopartikel und
- einen Felderzeuger (14b) für ein elektrisches Feld, der in Bezug auf den Transportkanal (12) derart angeordnet ist, dass das elektrische Feld mit zumindest im Wesentlichen entlang dem Verlauf des Transportkanals ausgerichteten Feldlinien erzeugt werden kann.

4. Transportsystem nach Anspruch 3,
**dadurch gekennzeichnet,**
**dass** der Felderzeuger (14b) für das elektrische Feld einen elektrischen Kondensator (20a, 20b) aufweist.

5. Transportsystem nach einem der vorangehenden Ansprüche,
**dadurch gekennzeichnet,**
**dass** der Transportkanal (12) in eine Ausstoßöffnung (13) für die Nanopartikel mündet.

6. Transportsystem nach einem der vorangehenden Ansprüche,
**dadurch gekennzeichnet,**
**dass** die Innenwand (26) des Transportkanals (12) radial zu dessen Verlauf beweglich ist und mit einem Aktor ausgestattet ist, derart, dass der Aktor Bewegungen der Innenwand (26) senkrecht zur Wandfläche erzeugen kann.

7. Transportsystem nach Anspruch 6,
**dadurch gekennzeichnet,**
**dass** der Aktor ein Piezoaktor (28) ist.

8. Verfahren zum Betrieb eines Transportsystems gemäß einem der vorangehenden Ansprüche,
**dadurch gekennzeichnet,**
**dass** in dem Transportkanal (12) ein statisches Feld erzeugt wird, welches aufrechterhalten bleibt, solange die Nanopartikel koninuierlich gefördert werden sollen.

9. Verfahren zum Betrieb eines Transportsystems gemäß einem der Ansprüche 1 bis 7,
**dadurch gekennzeichnet,**
**dass** in dem Transportkanal (12) ein pulsierendes Feld erzeugt wird, wobei durch Einstellung der Pulse eine Dosierung der Nanopartikel vorgenommen wird.

## Claims

1. Transport system for dry, magnetized nanoparticles, having
- a transport channel (12) for the nanoparticles and
- a field generator (14a) for a magnetic field, which is arranged with respect to the transport channel in such a manner that the magnetic field in the transport channel can be produced inhomogeneously with lines of force which are directed essentially along the profile of the transport channel.

2. Transport system according to Claim 1,
**characterized in that**
the field generator (14a) has an electrical coil (15), which is in the form of a winding around the transport channel (12), for the magnetic field.

3. Transport system for dry, electrically charged nanoparticles, having
- a transport channel (12) for the nanoparticles and
- a field generator (14b) for an electrical field, which is arranged with respect to the transport channel (12) in such a manner that the electrical field can be produced with field lines which are directed at least essentially along the profile of the transport channel.

4. Transport system according to Claim 3,
**characterized in that**
the field generator (14b) for the electrical field has an electrical capacitor (20a, 20b).

5. Transport system according to one of the preceding claims,
**characterized in that**
the transport channel (12) opens into an ejection opening (13) for the nanoparticles.

6. Transport system according to one of the preceding claims,
**characterized in that**
the inner wall (26) of the transport channel (12) can move radially with respect to its profile and is equipped with an actuator, in such a manner that the actuator can produce movements of the inner wall (26) at right angles to the wall surface.

7. Transport system according to Claim 6,
**characterized in that**
the actuator is a piezo-actuator (28).

8. Method for operation of a transport system according to one of the preceding claims,
**characterized in that**
a static field is produced in the transport channel (12) and is maintained as long as the nanoparticles are intended to be continuously conveyed.

9. Method for operation of a transport system according to one of Claims 1 to 7,
**characterized in that**
a pulsating field is produced in the transport channel (12), with the nanoparticles being metered by adjustment of the pulses.

## Revendications

1. Système de transport de nanoparticules sèches et magnétisées, qui comprend
- un canal (12) de transport des nanoparticules et
- un générateur (14a) d'un champ magnétique qui est disposé par rapport au canal de transport de façon à ce que le champ magnétique puisse être produit dans le canal de transport de manière inhomogène en ayant des lignes de champ dirigées sensiblement le long du tracé du canal de transport.

2. Système de transport suivant la revendication 1,
**caractérisé**
**en ce que** le producteur (14a) du champ magnétique a une bobine (15) électrique, qui est réalisée en enroulement autour du canal (12) de transport.

3. Système de transport de nanoparticules sèches et magnétisées, qui comprend
- un canal (12) de transport des nanoparticules et
- un générateur (14b) d'un champ électrique qui est disposé par rapport au canal (12) de transport de façon à ce que le champ électrique puisse être produit en ayant des lignes de champ dirigées au moins sensiblement le long du tracé du canal de transport.

4. Système de transport suivant la revendication 3,
**caractérisé**
**en ce que** le générateur (14b) du champ électrique a un condensateur (20a, 20b) électrique.

5. Système de transport suivant l'une des revendications précédentes,
**caractérisé**
**en ce que** le canal (12) de transport débouche dans une ouverture (13) d'expulsion des nanoparticules.

6. Système de transport suivant l'une des revendications précédentes,
**caractérisé**
**en ce que** la paroi (26) intérieure du canal (12) de transport est mobile radialement par rapport à son tracé et est équipée d'un actionneur de façon à ce que l'actionneur puisse produire des déplacements de la paroi (26) intérieure perpendiculairement à la surface de la paroi.

7. Système de transport suivant la revendication 6,
**caractérisé**
**en ce que** l'actionneur est un actionneur (28) piézo électrique.

8. Procédé pour faire fonctionner un système de transport suivant l'une des revendications précédentes,
**caractérisé**
**en ce qu'**on produit dans le canal (12) de transport un champ statique qui reste maintenu tant qu'il faut véhiculer continuellement les nanoparticules.

9. Procédé pour faire fonctionner un système de transport suivant l'une des revendications 1 à 7,
**caractérisé**
**en ce que** l'on produit dans le canal (12) de transport un champ pulsé en effectuant un dosage des nanoparticules par réglage des impulsions.
